(19) Europäisches Patentamt
European Patent Office
Office européen des brevets

(11) **EP 4 648 171 A1**

(12) **EUROPEAN PATENT APPLICATION**

(43) Date of publication:
**12.11.2025 Bulletin 2025/46**

(21) Application number: **24175219.5**

(22) Date of filing: **10.05.2024**

(51) International Patent Classification (IPC):
*H01M 10/42* (2006.01)    *B60L 58/10* (2019.01)
*G01R 31/367* (2019.01)    *H01M 10/48* (2006.01)
*H01M 10/633* (2014.01)

(52) Cooperative Patent Classification (CPC):
**H01M 10/48; B60L 58/10; G01R 31/367;**
**H01M 10/425; H01M 10/633;** B60L 2240/545;
B60L 2240/547; B60L 2240/549; H01M 10/625;
H01M 2010/4271; H01M 2220/20

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **VOLVO TRUCK CORPORATION**
**405 08 Göteborg (SE)**

(72) Inventors:
• **XU, Yang**
  **417 47 GÖTEBORG (SE)**
• **FRIBERG, Olle**
  **434 46 KUNGSBACKA (SE)**

(74) Representative: **Ström & Gulliksson AB**
**P.O. Box 4188**
**203 13 Malmö (SE)**

Remarks:
Amended claims in accordance with Rule 137(2)
EPC.

(54) **PREDICTION OF THERMAL RUNAWAY IN BATTERIES**

(57) A computer system is disclosed for training a model to predict a thermal runaway event in a battery cell, the computer system comprising processing circuitry configured to acquire data regarding one or more operating states associated with thermal runaway of a battery cell, and train a model to predict a thermal runaway event based on the acquired data using a cross-entropy cost function. A computer system for predicting a thermal runaway event in a battery cell using a trained model is also disclosed.

FIG. 2

## Description

### TECHNICAL FIELD

The disclosure relates generally to battery safety. In particular aspects, the disclosure relates to prediction of thermal runaway in batteries. The disclosure can be applied in heavy-duty vehicles, such as trucks, buses, multi-unit vehicle combinations, and construction equipment. The disclosure can also be applied to any marine vessel such as commercial marine vessels, leisure craft, motor boats, and/or autonomous marine vessel. Although the disclosure may be described with respect to a particular vehicle, the disclosure is not restricted to any particular vehicle. The disclosure can also be applied to other systems such as industrial systems and static systems.

### BACKGROUND

Electrical systems such as electric vehicles are often powered from a battery pack comprising a number of battery cells. Dependent on operating conditions, such as load, ambient temperature, and the like, such battery packs can reach high temperatures that may affect operation of the battery cells and, in some cases, reach dangerous temperatures that may have adverse effects on other components of the vehicle.

One particular issue is that of thermal runaway, where a high temperature inside a battery leads to a chemical reaction that produces further heat, increasing the temperature, and causing further chemical reactions that create yet more heat, and so on until failure (e.g. explosion and/or fire). This can occur in timeframes of a number of milliseconds, and is therefore extremely difficult to prevent once it has started.

It is currently not easy to predict thermal runaway in a battery cell ahead of time. Instead, detection is based on measurements of temperature, current, and voltage that are indicative of thermal runaway. Therefore, it is often too late to take corrective or preventative action, which leads to destruction of the cell and surrounding components.

It is therefore desired to develop a solution for battery safety that addresses or at least mitigates some of these issues.

### SUMMARY

This disclosure provides systems, methods and other approaches for training a model for predicting thermal runaway in a battery cell, and a method for implementing the model. Data regarding one or more operating states associated with thermal runaway of a battery cell is acquired. This data is then used to train a model to predict a thermal runaway event using a cross-entropy cost function. This approach enables a model to be trained more quickly and efficiently to identify upcoming thermal runaway events. The trained model can then be implemented to output an indication of an upcoming thermal runaway event based on online data from a battery cell. Therefore, corrective or preventative action can be taken in good time to avoid thermal runaway occurring.

According to a first aspect of the disclosure, there is provided a computer system for training a model to predict a thermal runaway event in a battery cell, the computer system comprising processing circuitry configured to acquire data regarding one or more operating states associated with thermal runaway of a battery cell, and train a model to predict a thermal runaway event based on the acquired data using a cross-entropy cost function.

The first aspect of the disclosure may seek to provide a computer system that can train a model to predict a thermal runaway event more quickly and efficiently. In particular, the use of a cross-entropy cost function provides computational efficiency due to its inherently simple arithmetic operations, fast convergence, and memory efficiency. The trained model can then be implemented to output an indication of an upcoming thermal runaway event based on online data from a battery cell, enabling corrective or preventative action to be taken.

Optionally in some examples, including in at least one preferred example, the acquired data comprises one or more of a battery internal state received from a battery management system, sensor data associated with the battery cell, and a signal from one or more actuators of the battery cell. A technical benefit may include that, by using internal states and/or actuator signals as well as sensor data, a more comprehensive understanding of the internal mechanisms of the battery cell can be achieved, leading to better training of the model and more accurate and reliable predictions.

Optionally in some examples, including in at least one preferred example, the battery internal state comprises one or more of a modelled value of the state of charge of the battery cell, a voltage of a fast RC circuit associated with the battery cell, and a voltage of a slow RC circuit associated with the battery cell. A technical benefit may include that a more comprehensive understanding of the internal mechanisms of the battery cell can be achieved, leading to better training of the model and more accurate and reliable predictions.

Optionally in some examples, including in at least one preferred example, the sensor data comprises one or more of a temperature of the battery cell, a current of the battery cell, a voltage of the battery cell, a temperature of a cooling system associated with the battery cell, and a flow rate of the cooling system. A technical benefit may include that different parameters of battery operation can be used to train the model and, when implemented, be used in prediction of a thermal runaway event.

Optionally in some examples, including in at least one preferred example, the signal comprises a signal from a contactor actuator and/or a balancer actuator of the battery cell. A technical benefit may include that a more comprehensive understanding of the internal mechanisms of the battery cell can be achieved, leading to better training of the model and more accurate and reliable predictions.

Optionally in some examples, including in at least one preferred example, the acquired data comprises historical battery cell data found to match characteristic data representing a thermal runaway event. A technical benefit may include that, by comparing the acquired data to data from previously observed thermal runaway events, its relevance can be ensured, leading to better training of the model and more accurate and reliable predictions.

Optionally in some examples, including in at least one preferred example, the historical battery cell data is captured by a device disposed locally to a battery cell, the device comprising a memory configured to store the captured battery cell data. A technical benefit may include that valuable information about what happens to a battery cell during a thermal runaway event can be captured, which is otherwise not possible due to the destructive nature of such events. The device may also comprise a thermally resistant housing in order that its components are protected in case of a thermal runaway event, ensuring valuable information is not lost.

Optionally in some examples, including in at least one preferred example, wherein the cross-entropy cost function comprises a sigmoid activation function based on a weighted sum of the acquired data. A technical benefit may include that a sigmoid activation function is a smooth and continuously differentiable function across its entire domain, which facilitates the use of gradient-based optimisation algorithms, ensuring stable and efficient training.

Optionally in some examples, including in at least one preferred example, the cross-entropy cost function is given by:

$$J(\mathbf{w}, b) = -\frac{1}{m}\sum_{i=1}^{m}\left(y_i \log\left(\sigma(\mathbf{w} \cdot \mathbf{x}_i + b)\right) + (1 - y_i)\log\left(1 - \sigma(\mathbf{w} \cdot \mathbf{x}_i + b)\right)\right)$$

where y is the actual output, **x** represents the acquired data, **w** is a vector of weights, b is a bias term, and $\sigma$ is the sigmoid activation function given by:

$$\sigma(z) = \frac{1}{1 + e^{-z}}$$

where z is the weighted sum of the acquired data given by:

$$z = \mathbf{w} \cdot \mathbf{x} + b$$

A technical benefit may include that a representation is provided of how close the predicted output is to the real output and that, as the cross-entropy cost function is convex, there is only one minimum to be found.

Optionally in some examples, including in at least one preferred example, the processing circuitry is configured to train the model by minimising the cross-entropy cost function using a stochastic gradient descent algorithm. A technical benefit may include that stochastic gradient descent is a versatile optimization algorithm that offers efficiency, faster convergence, regularization effects, memory efficiency, robustness to local minima, and parallelization capabilities.

Optionally in some examples, including in at least one preferred example, the processing circuitry is further configured to process the acquired data using at least one of data cleaning, feature scaling, and feature extraction before training the model. A technical benefit may include that missing and/or noisy data, outliers, duplication, and computed biases can be taken care of, data can be converted to a standard range such that all features have a consistent influence on the learning process, and a new feature subspace can be provided to reduce memory requirements and computational complexity.

Optionally in some examples, including in at least one preferred example, the model is a machine learning model. A technical benefit may include that the model can be trained robustly and accurately to provide predictions of thermal runaway events.

According to a second aspect of the disclosure, there is provided a computer system for predicting a thermal runaway event in a battery cell, the computer system comprising processing circuitry configured to acquire data regarding one or more operating states associated with a battery cell, input the acquired data to a model trained to predict a thermal runaway event in a battery cell, and receive an output from the model indicating if the acquired data corresponds to a thermal runaway event.

The second aspect of the disclosure may seek to provide a computer system capable of outputting an indication of an upcoming thermal runaway event based on online data from a battery cell. Therefore, corrective or preventative action can be taken in good time to avoid thermal runaway occurring, and thus avoiding damage or destruction of the cell and its surrounding components.

According to a third aspect of the disclosure, there is provided a vehicle comprising the computer system of any preceding claim. The third aspect of the disclosure may seek to provide a vehicle capable of predicting an upcoming thermal runaway event based on online data from a battery cell. Therefore, corrective or preventative action can be taken in good time to avoid thermal runaway occurring, and thus avoiding damage or destruction of the cell and its surrounding components. The model can even be trained and updated using data collected from operation of the vehicle itself.

According to a fourth aspect of the disclosure, there is provided a computer-implemented method for training a model to predict a thermal runaway event in a battery cell, the method comprising acquiring, by processing circuitry of a computer system, data regarding one or more operating states associated with thermal runaway of a battery cell, and training, by the processing circuitry, a model to predict a thermal runaway event based on the acquired data using a cross-entropy cost function.

The fourth aspect of the disclosure may seek to provide a computer-implemented method that can train a model to predict a thermal runaway event more quickly and efficiently. In particular, the use of a cross-entropy cost function provides computational efficiency due to its inherently simple arithmetic operations, fast convergence, and memory efficiency. The trained model can then be implemented to output an indication of an upcoming thermal runaway event based on online data from a battery cell, enabling corrective or preventative action to be taken.

According to a fifth aspect of the disclosure, there is provided a computer-implemented method for predicting a thermal runaway event in a battery cell, the method comprising acquiring, by processing circuitry of a computer system, data regarding one or more operating states associated with a battery cell, and inputting, by the processing circuitry, the acquired data to a model trained to predict a thermal runaway event in a battery cell, and receiving, by the processing circuitry, an output from the model indicating if the acquired data corresponds to a thermal runaway event.

The fifth aspect of the disclosure may seek to provide a computer-implemented method capable of outputting an indication of an upcoming thermal runaway event based on online data from a battery cell. Therefore, corrective or preventative action can be taken in good time to avoid thermal runaway occurring, and thus avoiding damage or destruction of the cell and its surrounding components.

According to a sixth aspect of the disclosure, there is provided a computer program product comprising program code for performing, when executed by processing circuitry, the computer-implemented method. The sixth aspect of the disclosure may seek to enable new vehicles and/or legacy vehicles to be conveniently configured, by software installation/update, to predict a thermal runaway event in a battery cell.

According to a seventh aspect of the disclosure, there is provided a non-transitory computer-readable storage medium comprising instructions, which when executed by processing circuitry, cause the processing circuitry to perform the computer-implemented method. The seventh aspect of the disclosure may seek to enable new vehicles and/or legacy vehicles to be conveniently configured, by software installation/update, to predict a thermal runaway event in a battery cell.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

Examples are described in more detail below with reference to the appended drawings.

**FIG. 1** is an exemplary view of a vehicle according to an example.
**FIG. 2** schematically shows a battery pack comprising a number of battery cells according to an example.
**FIG. 3** is a flow chart of a computer-implemented method according to an example.
**FIG. 4** is a flow chart of a computer-implemented method according to an example.
**FIG. 5** is a schematic diagram of a computer system for implementing examples disclosed herein.

Like reference numerals refer to like elements throughout the description.

**DETAILED DESCRIPTION**

The detailed description set forth below provides information and examples of the disclosed technology with sufficient detail to enable those skilled in the art to practice the disclosure.

Electrical systems such as electric vehicles are often powered from a battery pack comprising a number of battery cells. One particular issue is that of thermal runaway, where a high temperature inside a battery leads to a chemical reaction that can lead to failure (e.g. explosion and/or fire). It is currently not easy to predict thermal runaway in a battery cell ahead of time. Instead, detection is based on measurements of temperature, current, and voltage that are indicative of thermal runaway. Therefore, it is often too late to take corrective or preventative action, which leads to destruction of the cell and surrounding components.

To remedy this, systems, methods and other approaches are proposed for training a model for predicting thermal runaway in a battery cell, and a method for implementing the model. Data regarding one or more operating states associated with thermal runaway of a battery cell is acquired. This data is then used to train a model to predict a thermal runaway event using a cross-entropy cost function. This approach enables a model to be trained more quickly and efficiently to identify upcoming thermal runaway events. The trained model can then be implemented to output an indication of an upcoming thermal runaway event based on online data from a battery cell. Therefore, corrective or preventative action can be taken in good time to avoid thermal runaway occurring.

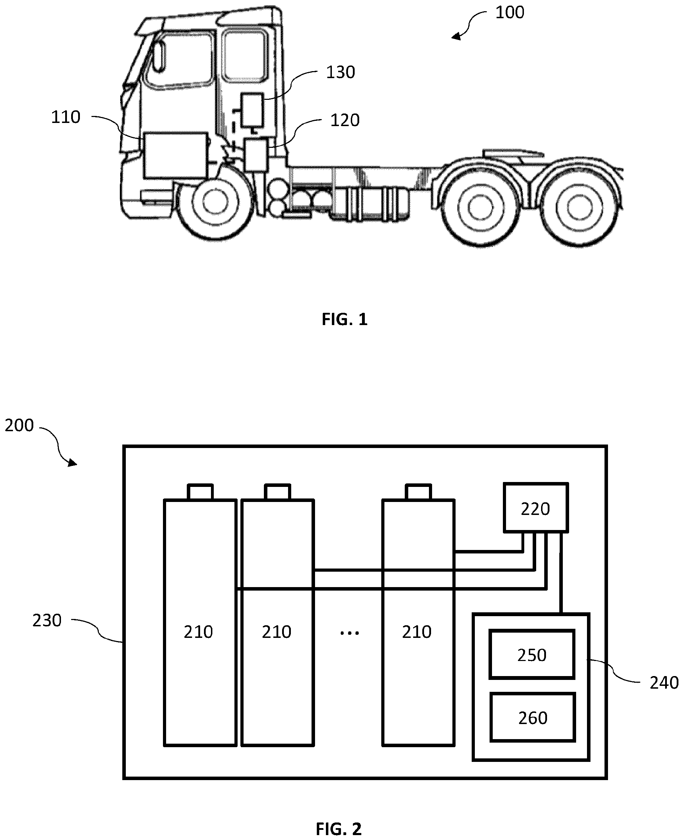

**FIG. 1** is an exemplary view of a vehicle **100**. Whilst the vehicle shown is a truck, the present disclosure is applicable to any suitable type of vehicle, such as buses, multi-unit vehicle combinations, construction equipment, and marine vessel, The present disclosure is also applicable to any type of battery system, not only battery systems for vehicles.

The vehicle **100** of **FIG. 1** is an at least partly electrically propelled vehicle **100**. To this end, the vehicle **100** comprises one or more motors **110** arranged to propel the vehicle **100** and one or more electrical power sources **120** configured to provide power to the one or motors **110** and/or other functionality of the vehicle **100**. The vehicle further comprises a thermal runaway predictor **130** arranged to predict thermal runaway in one or more battery cells of the vehicle **100**. The thermal runaway predictor **130** may be implemented, for example, as code running on a processing circuitry, or similar. The thermal runaway predictor **130** may comprise processing circuitry configured to implement various operations disclosed below. The thermal runaway predictor **130** may include a memory storing instructions that, when executed by the processing circuitry, cause the processing circuitry to perform the various operations.

Although the vehicle **100** of **FIG. 1** is described as an at least partly electrically propelled vehicle **100,** the vehicle **100** may, in some examples, be a vehicle **100** propelled solely by an internal combustion engine. In such examples, electrical power sources **120** may be used to power electronics controlling the internal combustion engine (fuel injection, etc.) or other systems of the vehicle (thermal control of a cabin of the vehicle, auxiliary equipment such as refrigerators, GPS etc.). In short, the thermal runaway predictor **130** may be utilized with any suitable electrical power source **120** at risk of experiencing thermal runaway or similar effects.

**FIG. 2** illustrates a battery pack **200** comprising a number of battery cells **210**. The battery pack **200** may be used to implement the electrical power sources **120** of the vehicle **100** shown in **FIG. 1.** Such a battery pack **200** can be used in vehicles, for example for providing power to electric motors and other electrically driven components of the vehicle. The battery pack **200** may be part of an energy storage system (ESS), which may be an ESS of a vehicle, e.g. the vehicle **100,** or of another system such as industrial system or static system.

The battery pack **200** of **FIG. 2** is shown as comprising three battery cells **210,** but the battery pack **200** may comprise any suitable number of battery cells **210**. The battery cells **210** may be any suitable form of battery cells, such as prismatic, cylindrical, or pouch battery cells. Each battery cell **210** may comprise a vent portion (not shown) configured to break or become detached if the pressure inside the battery cell **210** reaches a threshold value, for example due to a malfunction in the cell **210** such as thermal runaway. When this occurs, an opening is provided through which gas and/or other material can be released out of the battery cell **210** to prevent catastrophic failure of the cell **210**. Before implementation, the battery cells **210** may be subject to testing, for example in a climate chamber, to observe the behaviour of the cell **210** over time and under different conditions.

The battery cells **210** are communicatively coupled to a battery management unit (BMU) **220,** for example as known in the art. The BMU **220** is configured to monitor, control and/or manage various aspects of the operation of the battery cells **210** ensure the optimal performance, longevity, and safety of the battery pack **200**. For example, the may perform cell monitoring, balancing, state of charge (SoC) estimation, state of health (SoH) monitoring, safety management, thermal management, and/or communication for the battery pack **200**. The BMU **220** may be implemented, for example, as code running on a processing circuitry, or similar. The BMU **220** may comprise processing circuitry configured to implement various operations disclosed below. The BMU **220** may include a memory storing instructions that, when executed by the processing circuitry, cause the processing circuitry to perform the various operations. In some examples, the BMU **220** may be communicatively coupled to the thermal runaway predictor **130** shown in **FIG. 1,** for example as known in the art. In some examples, the thermal runaway predictor **130** may be implemented as part of the BMU **220**.

The battery pack **200** may further comprise a housing **230** enclosing the battery cells **210**. In some examples, the battery pack **200** comprises the thermal runaway predictor **130** and/or the BMU **220** are comprised in the housing **230**. In some examples, the thermal runaway predictor **130** and/or the BMU **220** is separate from the battery pack **200**.

It is currently not easy to determine valuable information about what happens to a battery cell **210** during a thermal runaway event, due to the destructive nature of such events. In some examples, the battery pack **200** therefore comprises a data recorder **240**. The data recorder **240** is configured to record dynamic information regarding performance of the battery pack **200** and the battery cells **210**, in particular regarding thermal runaway in a battery cell **210**. The data recorder **240** comprises a thermally resistant housing in order that its components are protected in case of a thermal runaway event. The data recorder **240** is therefore able to store valuable information from before and at the onset of a thermal runaway event that would otherwise be lost.

In particular, the data recorder **240** comprises a processor **250** configured to receive data regarding one or more operating states associated with the battery cells **210**. The data may comprise such as modelled values of SoC, voltage of a fast RC circuit, and voltage of a slow RC circuit, sensor data including temperature associated with the battery cells **210**, current associated with the battery cells **210**, voltage associated with the battery cells **210**, a cooling system temperature and a cooling flow rate, and signals from contactor and balancer actuators of the battery cells **210**.

The processor **250** is also configured to compare the received data to characteristic data representing a thermal runaway event to see if there is a match between the data. The characteristic data may be time series data and may be based on historical or modelled data of a thermal runaway event. Based on the comparison, for example by determining that the received data is within a threshold of the characteristic data, preferably a safe operation threshold, the processor **250** is configured to determine that a thermal runaway event is imminent and trigger storage of subsequently received data.

The data recorder **240** also comprises a memory **260** configured to store subsequently received data in response to the processor **250** determining that the received data matches the characteristic data. The information may be stored in the memory **260** for a certain time. In this way, the data recorder **240** is able to store valuable information from before and at the onset of a thermal runaway event that would otherwise be lost. As this data represents behavior of the battery pack **200** and the battery cells **210** before and during a thermal runaway event, the data then be used for training a model to predict thermal runaway in one or more of the battery cells **210** battery cells.

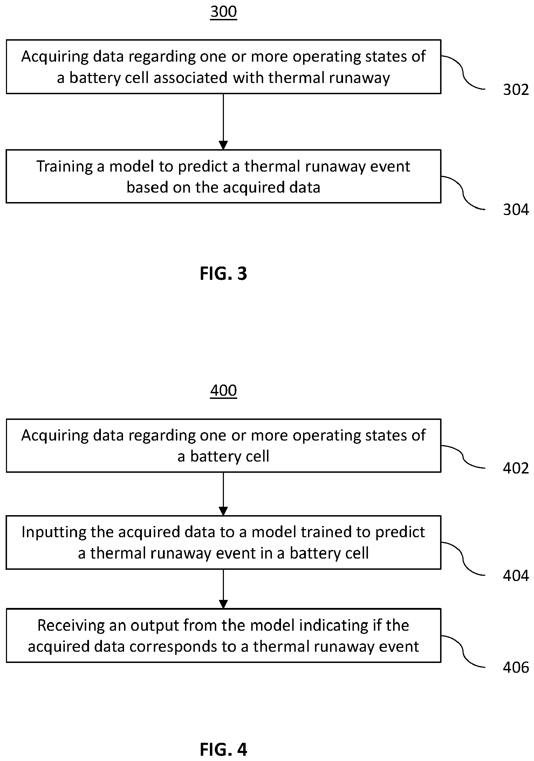

**FIG. 3** is a flow chart of a computer-implemented method **300** according to an example. The method **300** is for training a model, in particular a machine-learning model, to predict a thermal runaway event in a battery cell, such as one or more of the battery cells **210**. The method **300** may be implemented by processing circuitry of a computer system (e.g., the thermal runaway predictor **130** described in relation to **FIG. 1** or the BMU **220** described in relation to **FIG. 2).**

At **302**, data regarding one or more operating states of a battery cell **210** associated with thermal runaway of the battery cell **210** is acquired. The acquired data may comprise one or more of a battery internal state received from a battery management system (such as the BMU **220)**, sensor data associated with the battery cell **210**, and a signal from one or more actuators of the battery cell **210**. The battery internal state may comprise one or more of a modelled value of the SoC of the battery cell **210**, a voltage of a fast RC circuit associated with the battery cell **210**, and a voltage of a slow RC circuit associated with the battery cell **210**. The sensor data may comprise one or more of a temperature of the battery cell **210**, a current of the battery cell **210**, a voltage of the battery cell **210**, a temperature of a cooling system associated with the battery cell **210**, and a flow rate of coolant in the cooling system **210**. The signal from one or more actuators of the battery cell **210** may comprise a signal from a contactor actuator and/or a balancer actuator of the battery cell **210**. The acquired data may comprise historical battery cell data found to match characteristic data representing a thermal runaway event. For example, the historical battery cell data may be that captured by a device disposed locally to a battery cell, such as the data recorder **240.**

The acquired data may be used for training a model to predict thermal runaway. Because thermal runaway is a complex chemical and thermal reaction, sensor data alone may not be sufficient. For example, such data may not fully describe the internal states of the battery that lead to thermal runaway. Furthermore, such data can be inaccurate due to a sensor fault. By using internal states and/or actuator signals as well as sensor data, a more comprehensive understanding of the internal mechanisms of the battery cell can be achieved, leading to better training of the model and more accurate and reliable predictions.

In some examples, the acquired data may be processed before it is used for training a model. For example, on or more of data cleaning, feature scaling, and feature extraction may be used to transform the raw acquired data into a format that is suitable for the training. Data cleaning may include addressing missing and/or noisy data, detection and removal of outliers, and minimizing duplication and computed biases. Feature scaling may be used to convert data to a standard range such that all features have a consistent influence on the learning process. Feature extraction may be used to construct a new feature subspace to reduce memory requirements and computational complexity. Some suitable methods feature extraction are principal component analysis and linear discriminant analysis.

At **304**, a model is trained to predict a thermal runaway event based on the acquired data. In particular, a cross-entropy cost function is used to train the model. A cross-entropy cost function, also known as the cross-entropy loss or log loss, measures the dissimilarity between the predicted probability distributions and the true probability distributions of the classes.

In some examples, the cross-entropy cost function comprises a sigmoid activation function based on a weighted sum of the acquired data. For example, the cross-entropy cost function may be given by:

$$J(\mathbf{w}, b) = -\frac{1}{m} \sum_{i=1}^{m} \big( y_i \log\big(\sigma(\mathbf{w} \cdot \mathbf{x}_i + b)\big) + (1 - y_i) \log\big(1 - \sigma(\mathbf{w} \cdot \mathbf{x}_i + b)\big) \big) \quad (1)$$

where y is the actual output, $\mathbf{x}$ represents the acquired data, $\mathbf{w}$ is a vector of weights, $b$ is a bias term, and $\sigma$ is the sigmoid activation function given by:

$$\sigma(z) = \frac{1}{1 + e^{-z}} \quad\quad\quad (2)$$

where z is the weighted sum of the acquired data given by:

$$z = \mathbf{w} \cdot \mathbf{x} + b \quad\quad\quad (3)$$

In some examples, the model is trained by minimising the cross-entropy cost function using a stochastic gradient descent (SGD) algorithm. SGD is a versatile optimization algorithm that offers efficiency, faster convergence, regularization effects, memory efficiency, robustness to local minima, and parallelization capabilities. In some examples, the model is trained using other optimisation approaches, such as Adam or a second-order method such as Limited-memory Broyden-Fletcher-Goldfarb-Shanno (L-BFGS).

In this way, a tailored optimization method is proposed to train the model, which is more computationally efficient than other approaches such as neural networks. The model is then trained to identify thermal runaway events based on data relating to the battery cells **210,** such as battery internal states, sensor data, and actuator signals. After validation and testing, the trained model can be integrated into the thermal runaway predictor **130** or the BMU **220** and used for thermal runaway detection.

As discussed above, the method **300** may be used for training a machine-learning model. The described implementation is a supervised learning method using a cross-entropy cost function with SGD. In other examples, support-vector machines (SVMs) and neural networks (NNs) can also be used. A linear SVM approach may be similar in computational complexity to the approach described in the method **300,** whilst other approaches (e.g. nonlinear SVM or NN) may have higher computational complexity. Whilst the method **300** has been explained in the context of a machine-learning model, it will be appreciated that other modelling approaches may also be used. For example, first principles modelling may be used to describe the dynamics of a system using ordinary or partial differential equations. System identification may be used to build mathematical models based on input-output measurement data and statistical methods.

**FIG. 4** is a flow chart of a computer-implemented method **400** according to an example. The method **400** is for predicting a thermal runaway event in a battery cell, such as one or more of the battery cells **210.** The method **400** may be implemented by processing circuitry of a computer system (e.g., the thermal runaway predictor **130** described in relation to **FIG. 1** or the BMU **220** described in relation to **FIG. 2).**

At **402,** data regarding one or more operating states of a battery cell **210** is acquired. The acquired data may comprise one or more of a battery internal state received from a battery management system (such as the BMU **220),** sensor data associated with the battery cell **210,** and a signal from one or more actuators of the battery cell **210,** and may be similar in form and/or content to the data acquired at **302** in the method **300.**

At **404,** the acquired data is input to a model trained to predict a thermal runaway event in a battery cell **210.** The model may be trained using the method **300,** and therefore be capable of identifying thermal runaway events based on the acquired data. In this way, thermal runaway in a battery cell can be predicted ahead of time, and corrective or preventative action, can be taken in good time to avoid thermal runaway occurring. In particular, the model may be implemented by the thermal runaway predictor **130.**

At **406,** an output is received from the model indicating if the acquired data corresponds to a thermal runaway event. This enables corrective or preventative action to be taken by the BMU **220** or an operator of a system comprising the battery pack **200.** For example, one or more battery cells **210** of the battery pack **200** may be disconnected, or a current associated with the one or more battery cells **210** may be reduced. In this way, destruction or damage of the battery cells **210** and surrounding components can be avoided.

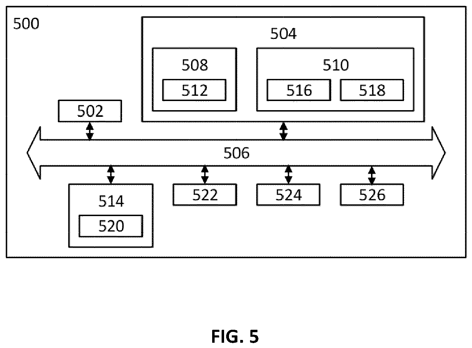

FIG. 5 is a schematic diagram of a computer system **500** for implementing examples disclosed herein. The computer system **500** is adapted to execute instructions from a computer-readable medium to perform these and/or any of the functions or processing described herein. The computer system **500** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **500** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **500** may comprise at least one computing device or electronic device capable of including firmware, hardware, and/or executing software instructions to implement the functionality described herein. The computer system **500** may include processing circuitry **502** (e.g., processing circuitry including one or more processor devices or control units), a memory **504,** and a system bus **506**. The computer system **500** may include at least one computing device having the processing circuitry **502**. The system bus **506** provides an interface for system components including, but not limited to, the memory **504** and the processing circuitry **502**. The processing circuitry **502** may include any number of hardware components for conducting data or signal processing or for executing computer code stored in memory **504.** The processing circuitry **502** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **502** may further include computer executable code that controls operation of the programmable device.

The system bus **506** may be any of several types of bus structures that may further interconnect to a memory bus (with or without a memory controller), a peripheral bus, and/or a local bus using any of a variety of bus architectures. The memory **504** may be one or more devices for storing data and/or computer code for completing or facilitating methods described herein. The memory **504** may include database components, object code components, script components, or other types of information structure for supporting the various activities herein. Any distributed or local memory device may be utilized with the systems and methods of this description. The memory **504** may be communicably connected to the processing circuitry **502** (e.g., via a circuit or any other wired, wireless, or network connection) and may include computer code for executing one or more processes described herein. The memory 504 may include non-volatile memory **508** (e.g., read-only memory (ROM), erasable programmable read-only memory (EPROM), electrically erasable programmable read-only memory (EEPROM), etc.), and volatile memory **510** (e.g., random-access memory (RAM)), or any other medium which can be used to carry or store desired program code in the form of machine-executable instructions or data structures and which can be accessed by a computer or other machine with processing circuitry **502**. A basic input/output system (BIOS) **512** may be stored in the non-volatile memory **508** and can include the basic routines that help to transfer information between elements within the computer system **500.**

The computer system **500** may further include or be coupled to a non-transitory computer-readable storage medium such as the storage device **514,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **514** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **514** and/or in the volatile memory **510,** which may include an operating system **516** and/or one or more program modules **518.** All or a portion of the examples disclosed herein may be implemented as a computer program **520** stored on a transitory or non-transitory computer-usable or computer-readable storage medium (e.g., single medium or multiple media), such as the storage device **514,** which includes complex programming instructions (e.g., complex computer-readable program code) to cause the processing circuitry **502** to carry out actions described herein. Thus, the computer-readable program code of the computer program **520** can comprise software instructions for implementing the functionality of the examples described herein when executed by the processing circuitry **502**. In some examples, the storage device **514** may be a computer program product (e.g., readable storage medium) storing the computer program **520** thereon, where at least a portion of a computer program **520** may be loadable (e.g., into a processor) for implementing the functionality of the examples described herein when executed by the processing circuitry **502**. The processing circuitry **502** may serve as a controller or control system for the computer system **500** that is to implement the functionality described herein.

The computer system **500** may include an input device interface **522** configured to receive input and selections to be communicated to the computer system **500** when executing instructions, such as from a keyboard, mouse, touch-sensitive surface, etc. Such input devices may be connected to the processing circuitry **502** through the input device interface **522** coupled to the system bus **506** but can be connected through other interfaces, such as a parallel port, an Institute of Electrical and Electronic Engineers (IEEE) 1394 serial port, a Universal Serial Bus (USB) port, an IR interface, and the like. The computer system **500** may include an output device interface **524** configured to forward output, such as to a display, a video display unit (e.g., a liquid crystal display (LCD) or a cathode ray tube (CRT)). The computer system **500** may include a communications interface **526** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

According to certain examples, there is also disclosed:

Example 1: A computer system (130, 220, 500) for training a model to predict a thermal runaway event in a battery cell (210), the computer system (130, 220, 500) comprising processing circuitry (502) configured to: acquire data regarding one or more operating states associated with thermal runaway of a battery cell (210); and train a model to predict a thermal runaway event based on the acquired data using a cross-entropy cost function.

Example 2: The computer system (130, 220, 500) of example 1, wherein the acquired data comprises one or more of a battery internal state received from a battery management system (220), sensor data associated with the battery cell (210), and a signal from one or more actuators of the battery cell (210).

Example 3: The computer system (130, 220, 500) of example 2, wherein the battery internal state comprises one or more of a modelled value of the state of charge of the battery cell (210), a voltage of a fast RC circuit associated with the battery cell (210), and a voltage of a slow RC circuit associated with the battery cell (210).

Example 4: The computer system (130, 220, 500) of example 2 or 3, wherein the sensor data comprises one or more of a temperature of the battery cell (210), a current of the battery cell (210), a voltage of the battery cell (210), a temperature of a cooling system associated with the battery cell (210), and a flow rate of the cooling system.

Example 5: The computer system (130, 220, 500) of any of examples 2 to 4, wherein the signal comprises a signal from a contactor actuator and/or a balancer actuator of the battery cell (210).

Example 6: The computer system (130, 220, 500) of any preceding example, wherein the acquired data comprises historical battery cell data found to match characteristic data representing a thermal runaway event.

Example 7: The computer system (130, 220, 500) of example 6, wherein the historical battery cell data is captured by a device (240) disposed locally to a battery cell (210), the device (240) comprising a memory (260) configured to store the captured battery cell data.

Example 8: The computer system (130, 220, 500) of any preceding example, wherein the cross-entropy cost function comprises a sigmoid activation function based on a weighted sum of the acquired data.

Example 9: The computer system (130, 220, 500) of any preceding example, wherein the cross-entropy cost function is given by:

$$J(\mathbf{w}, b) = -\frac{1}{m} \sum_{i=1}^{m} \left( y_i \log\big(\sigma(\mathbf{w} \cdot \mathbf{x}_i + b)\big) + (1 - y_i) \log\big(1 - \sigma(\mathbf{w} \cdot \mathbf{x}_i + b)\big) \right)$$

where $y$ is the actual output, $\mathbf{x}$ represents the acquired data, $\mathbf{w}$ is a vector of weights, $b$ is a bias term, and $\sigma$ is the sigmoid activation function given by:

$$\sigma(z) = \frac{1}{1 + e^{-z}}$$

where $z$ is the weighted sum of the acquired data given by:

$$z = \mathbf{w} \cdot \mathbf{x} + b$$

Example 10: The computer system (130, 220, 500) of any preceding example, wherein the processing circuitry (502) is configured to train the model by minimising the cross-entropy cost function using a stochastic gradient descent algorithm.

Example 11: The computer system (130, 220, 500) of any preceding example, wherein the processing circuitry (502) is further configured to process the acquired data using at least one of data cleaning, feature scaling, and feature extraction before training the model.

Example 12: The computer system (130, 220, 500) of any preceding example, wherein the model is a machine learning model.

Example 13: A computer system (130, 220, 500) for predicting a thermal runaway event in a battery cell (210), the computer system (130, 220, 500) comprising processing circuitry (502) configured to: acquire data regarding one or more operating states associated with a battery cell (210); input the acquired data to a model trained to predict a thermal runaway event in a battery cell (210); and receive an output from the model indicating if the acquired data corresponds to a thermal runaway event.

Example 14: A vehicle (100) comprising the computer system (130, 220, 500) of any preceding example.

Example 15: An energy storage system (ESS) comprising the computer system (130, 220, 500) of any preceding example.

Example 16: A computer-implemented method (300) for training a model to predict a thermal runaway event in a battery cell (210), the method comprising: acquiring (302), by processing circuitry (502) of a computer system (130, 220, 500), data regarding one or more operating states associated with thermal runaway of a battery cell (210); and training (304), by the processing circuitry (502), a model to predict a thermal runaway event based on the acquired data using a cross-entropy cost function.

Example 17: The computer-implemented method (300) of example 16, wherein the acquired data comprises one or more of a battery internal state received from a battery management system (220), sensor data associated with the battery cell (210), and a signal from one or more actuators of the battery cell (210).

Example 18: The computer-implemented method (300) of example 17, wherein the battery internal state comprises one or more of a modelled value of the state of charge of the battery cell (210), a voltage of a fast RC circuit associated with the battery cell (210), and a voltage of a slow RC circuit associated with the battery cell (210).

Example 19: The computer-implemented method (300) of example 17 or 18, wherein the sensor data comprises one or more of a temperature of the battery cell (210), a current of the battery cell (210), a voltage of the battery cell (210), a temperature of a cooling system associated with the battery cell (210), and a flow rate of the cooling system.

Example 20: The computer-implemented method (300) of any of examples 17 to 19, wherein the signal comprises a signal from a contactor actuator and/or a balancer actuator of the battery cell (210).

Example 21: The computer-implemented method (300) of any of examples 16 to 20, wherein the acquired data comprises historical battery cell data found to match characteristic data representing a thermal runaway event.

Example 22: The computer-implemented method (300) of example 21, wherein the historical battery cell data is captured by a device (240) disposed locally to a battery cell (210), the device (240) comprising a memory (260) configured to store the captured battery cell data.

Example 23: The computer-implemented method (300) of any of examples 16 to 22, wherein the cross-entropy cost function comprises a sigmoid activation function based on a weighted sum of the acquired data.

Example 24: The computer-implemented method (300) of any of examples 16 to 23, wherein the cross-entropy cost function is given by:

$$J(\mathbf{w}, b) = -\frac{1}{m} \sum_{i=1}^{m} \left( y_i \log\!\left(\sigma(\mathbf{w} \cdot \mathbf{x}_i + b)\right) + (1 - y_i) \log\!\left(1 - \sigma(\mathbf{w} \cdot \mathbf{x}_i + b)\right) \right)$$

where *y* is the actual output, **x** represents the acquired data, **w** is a vector of weights, *b* is a bias term, and $\sigma$ is the sigmoid activation function given by:

$$\sigma(z) = \frac{1}{1 + e^{-z}}$$

where z is the weighted sum of the acquired data given by:

$$z = \mathbf{w} \cdot \mathbf{x} + b$$

Example 25: The computer-implemented method (300) of any of examples 16 to 24, further comprising training the model by minimising the cross-entropy cost function using a stochastic gradient descent algorithm.

Example 26: The computer-implemented method (300) of any of examples 16 to 25, further comprising processing the acquired data using at least one of data cleaning, feature scaling, and feature extraction before training the model.

Example 27: The computer-implemented method (300) of any of examples 16 to 26, wherein the model is a machine learning model.

Example 28: A computer-implemented method (400) for predicting a thermal runaway event in a battery cell (210), the method comprising: acquiring (402), by processing circuitry (502) of a computer system (130, 220, 500), data regarding one or more operating states associated with a battery cell (210); and inputting (406), by the processing circuitry (502), the acquired data to a model trained to predict a thermal runaway event in a battery cell (210); and receiving (406), by the processing circuitry (502), an output from the model indicating if the acquired data corresponds to a thermal runaway event.

Example 29: A computer program product comprising program code for performing, when executed by processing circuitry (502), the computer-implemented method (300, 400) of any of examples 16 to 28.

Example 30: A non-transitory computer-readable storage medium comprising instructions, which when executed by processing circuitry (502), cause the processing circuitry to perform the computer-implemented method (300, 400) of any of examples 16 to 28.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system (130, 220, 500) for training a model to predict a thermal runaway event in a battery cell (210), the computer system (130, 220, 500) comprising processing circuitry (502) configured to:

   acquire data regarding one or more operating states associated with thermal runaway of a battery cell (210); and
   train a model to predict a thermal runaway event based on the acquired data using a cross-entropy cost function.

2. The computer system (130, 220, 500) of claim 1, wherein the acquired data comprises one or more of a battery internal state received from a battery management system (220), sensor data associated with the battery cell (210), and a signal from one or more actuators of the battery cell (210).

3. The computer system (130, 220, 500) of claim 2, wherein the battery internal state comprises one or more of a modelled value of the state of charge of the battery cell (210), a voltage of a fast RC circuit associated with the battery cell (210), and a voltage of a slow RC circuit associated with the battery cell (210).

4. The computer system (130, 220, 500) of claim 2 or 3, wherein the sensor data comprises one or more of a temperature of the battery cell (210), a current of the battery cell (210), a voltage of the battery cell (210), a temperature of a cooling system associated with the battery cell (210), and a flow rate of the cooling system.

5. The computer system (130, 220, 500) of any of claims 2 to 4, wherein the signal comprises a signal from a contactor actuator and/or a balancer actuator of the battery cell (210).

6. The computer system (130, 220, 500) of any preceding claim, wherein the cross-entropy cost function comprises a sigmoid activation function based on a weighted sum of the acquired data.

7. The computer system (130, 220, 500) of any preceding claim, wherein the cross-entropy cost function is given by:

$$J(\mathbf{w}, b) = -\frac{1}{m} \sum_{i=1}^{m} \left( y_i \log\left(\sigma(\mathbf{w} \cdot \mathbf{x}_i + b)\right) + (1 - y_i) \log\left(1 - \sigma(\mathbf{w} \cdot \mathbf{x}_i + b)\right) \right)$$

where $y$ is the actual output, $\mathbf{x}$ represents the acquired data, $\mathbf{w}$ is a vector of weights, $b$ is a bias term, and $\sigma$ is the sigmoid activation function given by:

$$\sigma(z) = \frac{1}{1 + e^{-z}}$$

where $z$ is the weighted sum of the acquired data given by:

$$z = \mathbf{w} \cdot \mathbf{x} + b$$

8. The computer system (130, 220, 500) of any preceding claim, wherein the processing circuitry (502) is configured to train the model by minimising the cross-entropy cost function using a stochastic gradient descent algorithm.

9. The computer system (130, 220, 500) of any preceding claim, wherein the processing circuitry (502) is further configured to process the acquired data using at least one of data cleaning, feature scaling, and feature extraction before training the model.

10. A computer system (130, 220, 500) for predicting a thermal runaway event in a battery cell (210), the computer system (130, 220, 500) comprising processing circuitry (502) configured to:

   acquire data regarding one or more operating states associated with a battery cell (210);
   input the acquired data to a model trained to predict a thermal runaway event in a battery cell (210); and
   receive an output from the model indicating if the acquired data corresponds to a thermal runaway event.

11. A vehicle (100) comprising the computer system (130, 220, 500) of any preceding claim.

12. A computer-implemented method (300) for training a model to predict a thermal runaway event in a battery cell (210), the method comprising:

   acquiring (302), by processing circuitry (502) of a computer system (130, 220, 500), data regarding one or more operating states associated with thermal runaway of a battery cell (210); and
   training (304), by the processing circuitry (502), a model to predict a thermal runaway event based on the acquired data using a cross-entropy cost function.

13. A computer-implemented method (400) for predicting a thermal runaway event in a battery cell (210), the method comprising:

acquiring (402), by processing circuitry (502) of a computer system (130, 220, 500), data regarding one or more operating states associated with a battery cell (210); and
inputting (406), by the processing circuitry (502), the acquired data to a model trained to predict a thermal runaway event in a battery cell (210); and
receiving (406), by the processing circuitry (502), an output from the model indicating if the acquired data corresponds to a thermal runaway event.

14. A computer program product comprising program code for performing, when executed by processing circuitry (502), the computer-implemented method (300, 400) of claim 12 or 13.

15. A non-transitory computer-readable storage medium comprising instructions, which when executed by processing circuitry (502), cause the processing circuitry to perform the computer-implemented method (300, 400) of claim 12 or 13.

**Amended claims in accordance with Rule 137(2) EPC.**

1. A computer system (130, 220, 500) for training a model to predict a thermal runaway event in a battery cell (210), the computer system (130, 220, 500) comprising processing circuitry (502) configured to:

acquire data regarding one or more operating states associated with thermal runaway of a battery cell (210); and
train a model to predict a thermal runaway event based on the acquired data using a cross-entropy cost function.

2. The computer system (130, 220, 500) of claim 1, wherein the acquired data comprises one or more of a battery internal state received from a battery management system (220), sensor data associated with the battery cell (210), and a signal from one or more actuators of the battery cell (210).

3. The computer system (130, 220, 500) of claim 2, wherein the battery internal state comprises one or more of a modelled value of the state of charge of the battery cell (210), a voltage of a fast RC circuit associated with the battery cell (210), and a voltage of a slow RC circuit associated with the battery cell (210).

4. The computer system (130, 220, 500) of claim 2 or 3, wherein the sensor data comprises one or more of a temperature of the battery cell (210), a current of the battery cell (210), a voltage of the battery cell (210), a temperature of a cooling system associated with the battery cell (210), and a flow rate of the cooling system.

5. The computer system (130, 220, 500) of any of claims 2 to 4, wherein the signal comprises a signal from a contactor actuator and/or a balancer actuator of the battery cell (210).

6. The computer system (130, 220, 500) of any preceding claim, wherein the cross-entropy cost function comprises a sigmoid activation function based on a weighted sum of the acquired data.

7. The computer system (130, 220, 500) of any preceding claim, wherein the cross-entropy cost function is given by:

$$J(\mathbf{w}, b) = -\frac{1}{m} \sum_{i=1}^{m} \left( y_i \log\big(\sigma(\mathbf{w} \cdot \mathbf{x}_i + b)\big) + (1 - y_i) \log\big(1 - \sigma(\mathbf{w} \cdot \mathbf{x}_i + b)\big) \right)$$

where y is the actual output, $\mathbf{x}$ represents the acquired data, $\mathbf{w}$ is a vector of weights, $b$ is a bias term, and $\sigma$ is the sigmoid activation function given by:

$$\sigma(z) = \frac{1}{1 + e^{-z}}$$

where $z$ is the weighted sum of the acquired data given by:

$$z = \mathbf{w} \cdot \mathbf{x} + b$$

8. The computer system (130, 220, 500) of any preceding claim, wherein the processing circuitry (502) is configured to train the model by minimising the cross-entropy cost function using a stochastic gradient descent algorithm.

9. The computer system (130, 220, 500) of any preceding claim, wherein the processing circuitry (502) is further configured to process the acquired data using at least one of data cleaning, feature scaling, and feature extraction before training the model.

10. A computer system (130, 220, 500) for predicting a thermal runaway event in a battery cell (210), the computer system (130, 220, 500) comprising processing circuitry (502) configured to:

   acquire data regarding one or more operating states associated with a battery cell (210);
   input the acquired data to a model trained using a cross-entropy cost function to predict a thermal runaway event in a battery cell (210); and
   receive an output from the model indicating if the acquired data corresponds to a thermal runaway event.

11. A vehicle (100) comprising the computer system (130, 220, 500) of any preceding claim.

12. A computer-implemented method (300) for training a model to predict a thermal runaway event in a battery cell (210), the method comprising:

   acquiring (302), by processing circuitry (502) of a computer system (130, 220, 500), data regarding one or more operating states associated with thermal runaway of a battery cell (210); and
   training (304), by the processing circuitry (502), a model to predict a thermal runaway event based on the acquired data using a cross-entropy cost function.

13. A computer-implemented method (400) for predicting a thermal runaway event in a battery cell (210), the method comprising:

   acquiring (402), by processing circuitry (502) of a computer system (130, 220, 500), data regarding one or more operating states associated with a battery cell (210); and
   inputting (406), by the processing circuitry (502), the acquired data to a model trained using a cross-entropy cost function to predict a thermal runaway event in a battery cell (210); and
   receiving (406), by the processing circuitry (502), an output from the model indicating if the acquired data corresponds to a thermal runaway event.

14. A computer program product comprising program code for performing, when executed by processing circuitry (502), the computer-implemented method (300, 400) of claim 12 or 13.

15. A non-transitory computer-readable storage medium comprising instructions, which when executed by processing circuitry (502), cause the processing circuitry to perform the computer-implemented method (300, 400) of claim 12 or 13.

**FIG. 1**

**FIG. 2**

300

Acquiring data regarding one or more operating states of a battery cell associated with thermal runaway — 302

Training a model to predict a thermal runaway event based on the acquired data — 304

**FIG. 3**

400

Acquiring data regarding one or more operating states of a battery cell — 402

Inputting the acquired data to a model trained to predict a thermal runaway event in a battery cell — 404

Receiving an output from the model indicating if the acquired data corresponds to a thermal runaway event — 406

**FIG. 4**

**FIG. 5**

## EUROPEAN SEARCH REPORT

Europäisches
Patentamt
European
Patent Office
Office européen
des brevets

**Application Number**

EP 24 17 5219

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 117 630 672 A (ROBERT BOSCH CO LTD) 1 March 2024 (2024-03-01) * abstract; claims 1-10 * ----- | 1-15 | INV. H01M10/42 B60L58/10 G01R31/367 H01M10/48 H01M10/633 |
| X | EP 4 207 432 A2 (CHONGQING CHANGAN NEW ENERGY VEHICLES TECH CO LTD [CN]) 5 July 2023 (2023-07-05) * paragraph [0007] - paragraph [0011] * ----- | 10,11, 13-15 | |
| X | CN 113 437 371 A (UNIV HUNAN; CHINA AUTOMOTIVE ENG RES INST) 24 September 2021 (2021-09-24) * Abstract; paragraph [0006] - paragraph [0024] * ----- | 10,11, 13-15 | |

**TECHNICAL FIELDS SEARCHED (IPC)**

H01M
G01R
B60L

The present search report has been drawn up for all claims

| Place of search | Date of completion of the search | Examiner |
|---|---|---|
| Munich | 11 October 2024 | Topalov, Angel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.................................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 5219

This annex lists the patent family members relating to the patent documents cited in the above-mentioned European search report.
The members are as contained in the European Patent Office EDP file on
The European Patent Office is in no way liable for these particulars which are merely given for the purpose of information.

11-10-2024

| Patent document cited in search report | | Publication date | Patent family member(s) | | Publication date |
|---|---|---|---|---|---|
| CN 117630672 | A | 01-03-2024 | CN | 117630672 A | 01-03-2024 |
| | | | DE | 102022208932 A1 | 29-02-2024 |
| EP 4207432 | A2 | 05-07-2023 | CN | 114325406 A | 12-04-2022 |
| | | | EP | 4207432 A2 | 05-07-2023 |
| CN 113437371 | A | 24-09-2021 | NONE | | |

EPO FORM P0459

For more details about this annex : see Official Journal of the European Patent Office, No. 12/82